# EUROPÄISCHE PATENTSCHRIFT

(11) **EP 2 068 228 B1**
(45) Veröffentlichungstag und Bekanntmachung des Hinweises auf die Patenterteilung: **24.06.2015**
(21) Anmeldenummer: 08169771.6
(22) Anmeldetag: 24.11.2008
(51) Int. Cl.: G06F 1/18, H05K 1/14

(54) **Datenverarbeitungssystem**
Data processing system
Système de traitement des données

(30) Priorität: 06.12.2007 DE 102007058724
(43) Veröffentlichungstag der Anmeldung: 10.06.2009
(73) Patentinhaber: Fujitsu Technology Solutions Intellectual Property GmbH, 80807 München (DE)
(72) Erfinder: Heinrichs, Hans-Jürgen, 33184, Altenbeken (DE); Sell, Melanie, 33102 Paderborn (DE)
(74) Vertreter: Epping - Hermann - Fischer

(56) Entgegenhaltungen:
- US-A1- 2004 160 745
- US-A1- 2007 236 903
- US-B1- 6 533 587

## Beschreibung

Die Erfindung betrifft ein Datenverarbeitungssystem, mit einer Hauptplatine, wobei die Hauptplatine zumindest eine erste Steckkontaktleiste aufweist, in welcher eine erste RISER-Karte aufgenommen ist und in die erste RISER-Karte eine erste Tochterkarte derart aufgenommen ist, dass die erste Tochterkarte parallel zur Hauptplatine angeordnet ist. Weiter weist das Datenverarbeitungssystem eine zweite Steckkontaktleiste auf in der eine zweite RISER-Karte aufgenommen ist, wobei in der zweiten RISER-Karte eine zweite Tochterkarte derart aufgenommen ist, dass die zweite Tochterkarte parallel zur Hauptplatine angeordnet ist, wobei die erste Steckkontaktleise und die zweite Steckkontaktleiste jeweils an zueinander gegenüber liegenden Außenseiten der Hauptplatine angeordnet sind.

Ein derartiges Datenverarbeitungssystem ist z.B. aus der US 6 533 587 B1 bekannt.

Eine weiteres ähnliches Datenverarbeitungssystem zur Aufnahme von Speicherkarten in RISER-Karten ist aus der US 2004/160745 A1 bekannt.

Die US 2007/0236903 A1 offenbart einen Computer mit übereinander angeordneten Tochterkarten, die von RISER-Karten gehalten werden.

Solche Datenverarbeitungssysteme finden zum Beispiel in so genannten BLADE-Servern Verwendung. Die Besonderheit der BLADE-Server liegt darin, dass mehrere Datenverarbeitungssysteme der Eingangs genannten Art nebeneinander in einem Baugruppenträger angeordnet sind. Die einzelnen Datenverarbeitungssysteme sind in Einschübe montiert und werden in den Baugruppenträger eingeschoben. Über eine gemeinsame Rückseitenplatine, auch BACK-PLANE oder MID-PLANE genannt, sind die einzelnen Datenverarbeitungssysteme miteinander verbunden. Jedes der Datenverarbeitungssysteme hat Schnittstellen ausgebildet, die das Datenverarbeitungssystem mit der gemeinsamen Rückseitenplatine verbinden. Die einzelnen Datenverarbeitungssysteme sind meist sehr flach ausgebildet und benötigen nur sehr wenig Raum. Daher kommt auch die Bezeichnung BLADE-Server, da jedes einzelne Datenverarbeitungssystem eines BLADE-Servers einem Blatt ähnelt. Des Weiteren sind die einzelnen Datenverarbeitungssysteme über eine gemeinsame Energieversorgung und eine gemeinsame Lüftung mit Energie und Kühlluft versorgt. Somit teilen sich alle Datenverarbeitungssysteme in dem Baugruppenträger eine gemeinsame Energie- und Kühlluftversorgung.

Um eine hohe Variabilität der einzelnen Datenverarbeitungssysteme zu erzielen, sollen trotz geringem Raumbedarf zusätzliche Computerkarten, im Folgenden als Tochterkarten bezeichnet, in die Einschübe einbaubar sein. Um dies zu bewerkstelligen, werden so genannte RISER-Karten verwendet, mit denen eine parallele Anordnung einer Tochterkarte zur Hauptplatine platzsparend möglich ist.

Eine RISER-Karte ist eine Computererweiterungskarte für ein Datenverarbeitungssystem, die einsetzbar ist, um eine oder mehrere Tochterkarten in ihrer räumlichen Lage im Datenverarbeitungssystem parallel zur Hauptplatine anzuordnen. RISER-Karten sind für verschiedene Steckkontaktleisten im Handel erhältlich. Dabei werden passive und aktive RISER-Karten unterschieden, wobei die passiven RISER-Karten lediglich die Kontaktanschlüsse der Steckkontaktleisten elektrisch verlängern. Aktive RISER-Karten haben zudem eine Steuerelektronik, welche für die Ressourcenverwaltung der mit der RISER-Karte verbundenen Tochterkarte verwendet wird.

Aufgrund der oben erwähnten sehr flachen Ausführung der einzelnen Datenverarbeitungssysteme ist bereits die Anordnung einer zweiten Tochterkarte in dem Datenverarbeitungssystem mit Problemen behaftet.

Es ist demzufolge die Aufgabe der Erfindung, die Anordnung einer zweiten Tochterkarte in dem Datenverarbeitungssystem kostengünstig zu ermöglichen.

Diese Aufgabe wird durch dadurch gelöst, dass jede Tochterkarte jeweils eine I/O-Schnittstelle umfasst, die I/O-Schnittstellen der Tochterkarten jeweils mit einer gemeinsamen Rückseitenplatine zusammenwirken und zur gemeinsamen Rückseitenplatine hin gerichtet sind, und die erste Tochterkarte zu der zweiten Tochterkarte um eine parallel zur Hauptplatine verlaufenden virtuellen Achse um 180° gedreht angeordnet ist und die erste Tochterkarte und die zweite Tochterkarte form- und funktionsgleich sind.

Die Erfindung ermöglicht, dass zwei bau- und funktionsgleiche Tochterkarten in ein und demselben Datenverarbeitungssystem verwendet werden können.

Diese zwei form- und funktionsgleichen Tochterkarten, welche zum Beispiel zur Ausbildung von zwei form- und funktionsgleichen I/O-Schnittstellen verwendet werden, sind auf diese Art und Weise in das oben beschriebene Datenverarbeitungssystem integrierbar, da die räumliche Situation in dem Einschub optimal genutzt ist. Vorteilhaft wird damit vermieden zur Anordnung der Tochterkarten nebeneinander inmitten der Hauptplatine eine weitere Steckkontaktleiste vorsehen zu müssen. Dies wäre aufgrund der dichten Leiterbahnenstruktur auf der Hauptplatine nur mit sehr großem Aufwand möglich.

Somit können mit der Erfindung Produktionskosten eingespart werden, da nur ein Typ für eine Tochterkarte produziert und bereitgehalten werden muss.

Vorteilhaft wird dabei erreicht, dass mit der weiteren Tochterkarte eine Variabilität der verfügbaren I/O-Schnittstellen für das Datenverarbeitungssystem erhöht wird. Denn gemäß dem Prinzip der vorliegenden Erfindung sind in einem Datenverarbeitungssystem zwei Tochterkarten, welche I/O-Schnittstellen, wie zum Beispiel Glasfaser-Schnittstellen, Ethernet-Schnittstellen oder Infiniband-Schnittstellen bereitstellen, einsetzbar.

Als weiterer Vorteil ermöglichen die erfindungsgemäßen Maßnahmen hohe Datenübertragungsraten, denn hohe Datenübertragungsraten erfordern die erfindungsgemäß gegebene direkte Ausbildung der I/O-Schnittstelle auf der Tochterkarte, womit ein möglichst kurzer Weg für die Datensignale ausgebildet ist. Damit werden Übertragungsfehler vermieden, die entstehen können, wenn die Datensignale von der Tochterkarte, auf die Hauptplatine und von dort zur I/O-Schnittstelle geleitet werden.

Mit den beschriebenen Maßnahmen wird vorteilhaft ein weiteres Problem vermieden. Dieses bezieht sich auf die Kühlluftführung in dem Datenverarbeitungssystem. Durch die Anordnung der ersten Steckkontaktleiste und der zweiten Steckkontaktleiste an zueinander gegenüberliegenden Außenseiten der Hauptplatine wird die Kühlluftführung im Datenverarbeitungssystem nicht behindert.

Dementsprechend ist gemäß einer vorteilhaften Weiterbildung vorgesehen, dass die Tochterkarte eine Steckkontaktleiste aufweist, mit welcher eine RISER-Karte aufgenommen ist, und die Tochterkarte darüber hinaus eine Leiterplattendurchführung aufweist, welche von der Steckkontaktleiste umgeben ist. In der Leiterplattendurchführung ist die RISER-Karte aufgenommen. Somit ist die RISER-Karte durch die Tochterkarte hindurchgesteckt.

Gemäß einer vorteilhaften Weiterbildung ist die Tochterkarte entlang einer vorbestimmbaren Höhe der RISER-Karte verschiebbar. Die RISER-Karte weist dazu Leiterbahnen auf, an denen elektrische Kontaktfedern der Steckkontaktleiste entlanggleiten können. Damit ist es ermöglicht, ein und dieselbe Tochterkarte mit der ersten Steckkartenleiste mittels der ersten RISER-Karte zu koppeln, als auch sie mit der zweiten Steckkartenleiste mit der zweiten RISER-Karte zu koppeln, die an der gegenüber liegenden Außenseite an der zweiten Steckkartenleiste angeordnet ist. Somit sind zwei baugleiche und funktionsgleiche Tochterkarten sowohl an der ersten Steckkontaktleiste als auch an der zweiten Steckkontaktleiste anschließbar. Die beiden Tochterkarten sind im Einbauzustand derart zueinander angeordnet, als wären sie lediglich um eine parallel zur Ebene der Hauptplatine verlaufende Achse herumgeklappt.

Eine andere vorteilhafte Weiterbildung des vorstehend beschriebenen Prinzips sieht vor, an der ersten und an der zweiten RISER-Karte jeweils eine erste Steckkontaktleiste beziehungsweise eine zweite Steckkontaktleise vorzusehen. Diese erste beziehungsweise zweite Steckkontaktleiste ist gegenüberliegend der Seite der RISER-Karte angeordnet, mit welcher die RISER-Karte in die erste oder zweite Steckkontaktleise der Hauptplatine eingeführt wird. Damit bildet die erste RISER-Karte mit ihrer ersten Steckkontaktleiste eine Aufnahme zur Anordnung der ersten Tochterkarte und zur Kontaktierung der ersten Tochterkarte mit der ersten Steckkontaktleiste der Hauptplatine des Datenverarbeitungssystems. Die zweite RISER-Karte bildet analog dazu mit der zweiten Steckkontaktleise zur Aufnahme der zweiten Tochterkarte eine elektrische Kopplung der zweiten Tochterkarte an die zweite Steckkontaktleiste der Hauptplatine des Datenverarbeitungssystems.

Im Folgenden ist die Erfindung mittels sechs Figuren und anhand zweier Ausführungsbeispiele näher erläutert.

Es zeigt:
die Figur 1 eine schematische Darstellung eines Datenverarbeitungssystems,
die Figur 2 ein erstes Ausführungsbeispiel,
die Figur 3 ein zweites Ausführungsbeispiel,
die Figur 4 die Anordnung zweier gleicher Tochterkarten in einer Draufsicht gemäß dem ersten Ausführungsbeispiel,
die Figur 5 die Anordnung zweier gleicher Tochterkarten in einer Draufsicht gemäß dem zweiten Ausführungsbeispiel, und
die Figur 6 die Anordnung zweier gleicher Tochterkarten gemäß dem zweiten Ausführungsbeispiel in perspektivischer Ansicht.

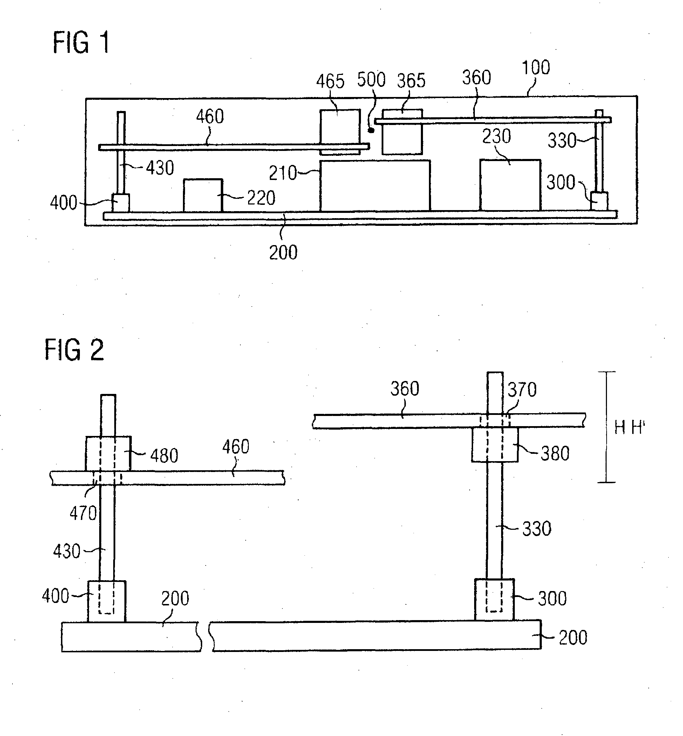

Die schematische Darstellung der Figur 1 zeigt ein Datenverarbeitungssystem 100 mit einer Hauptplatine 200, auf der zumindest eine I/O-Schnittstelle 210 angeordnet ist. Weiter umfasst die Hauptplatine des Datenverarbeitungssystems 100 einen Hauptprozessor 220 und einen RAM-Arbeitsspeicher 230. RAM bedeutet Random Access Memory und beschreibt damit einen elektronischen Speicher mit wahlfreiem Zugriff, der als Arbeitsspeicher 230 in dem Datenverarbeitungssystem 100 verwendet wird. Diese Komponenten sind direkt oder indirekt jeweils auf der Hauptplatine 200 angeordnet. Die Figur 1 zeigt nun weiter eine erste Steckkontaktleiste 300, in die eine erste RISER-Karte 330 eingesteckt ist. Mit der ersten RISER-Karte 330 ist eine erste Tochterkarte 360 gekoppelt, die ihrerseits eine I/O-Schnittstelle 365 umfasst. Die erste Tochterkarte 360 ist mittels der ersten RISER-Karte 330 mit der ersten Steckkontaktleiste 300 gekoppelt.

Weiter weist das Datenverarbeitungssystem 100 eine zweite Steckkontaktleiste 400 auf, welche an einer zur ersten Steckkontaktleiste 300 gegenüberliegenden Außenseite der Hauptplatine 200 des Datenverarbeitungssystems 100 angeordnet ist. In der zweiten Steckkontaktleiste 400 ist eine zweite RISER-Karte 430 aufgenommen. Eine zweite Tochterkarte 460 ist mit der RISER-Karte gekoppelt. Mittels dieser Anordnung ist die zweite Tochterkarte 460 in dem Datenverarbeitungssystem 100 so angeordnet, als wäre sie gemäß einer Achsenspiegelung an einer Spiegelachse 500 aus der ersten Tochterkarte 360 gespiegelt.

Die schematische Darstellung der Figur 1 zeigt das Datenverarbeitungssystem 100 von einer in dieser Figur nicht dargestellten gemeinsamen Rückseitenplatine 600 aus betrachtet. Die gemeinsame Rückseitenplatine 600 ist zur Spiegelachse 500 in vertikaler Richtung angeordnet. Das Datenverarbeitungssystem 100 ist in einem Gehäuse angeordnet, das in einen Einbaurahmen einschiebbar ist. Gehäuse und Einbaurahmen sind nicht dargestellt. Eine Vielzahl derartiger Datenverarbeitungssysteme 100 bildet in einem Einbaurahmen ein BLADE-Serversystem.

Die erste und die zweite RISER-Karte 330 und 430 bilden damit im Wesentlichen die elektrischen Kontakte zwischen den Tochterkarten 360, 460 und der Hauptplatine 200. Sie bewirken demzufolge eine Übertragung der elektrischen Signale von der Hauptplatine 200 zur jeweiligen Tochterkarte 360,460. Zur Befestigung der jeweiligen Tochterkarte 360,460 und zur mechanischen Fixierung der Lage der Tochterkarte 360,460 im Datenverarbeitungssystem 100 können mechanische Mittel wie Schrauben und Abstandshülsen vorgesehen werden.

Die RISER-Karte 330,430 ist jeweils dazu ausgebildet, eine Tochterkarte 360,460 derart aufzunehmen, dass die Tochterkarte in ihrer räumlichen Lage parallel zur Hauptplatine 200 angeordnet ist. Jede Tochterkarte 360,460 umfasst eine I/O-Schnittstelle 365,465. Im Ausführungsbeispiel sind die Tochterkarten 360 und 460 form- und funktionsgleich. Zur Darstellung des Anordnungsprinzips ist die Spiegelachse 500 aufgenommen, welche kein mechanisches Element der gesamten Anordnung ist, sondern lediglich eine virtuelle Spiegelachse darstellt. Die Tochterkarten sind in dem Datenverarbeitungssystem so angeordnet, als wären sie an der Spiegelachse 500 zueinander gespiegelt. Das heißt, die zweite Tochterkarte 460 entspricht einer Achsenspiegelung der ersten Tochterkarte 360 an der Spiegelachse 500. Die Anordnung der beiden Tochterkarten 360 und 460 ist demzufolge gemäß einer Achsenspiegelung ausgeführt. Eine Achsenspiegelung ist eine Spiegelung durch eine Gerade. Die Achsenspiegelung ordnet jedem Punkt P einen Bildpunkt P' zu, der dadurch bestimmt ist, dass die Verbindungsstrecke P-P' von der Achse rechtwinklig halbiert wird. Fixpunkte einer Achsenspiegelung sind die Punkte der Spiegelachse. Im dreidimensionalen Raum entspricht die Achsenspiegelung einer Drehung eines Körpers um 180° um die Spiegelachse. Ein Objekt, das zusammen mit der Spiegelachse in einer Ebene liegt, wird dabei in die gleiche Ebene umgeklappt.

Angewendet auf das Ausführungsbeispiel der Figur 1 heißt das, dass zwei funktions- und formgleiche Tochterkarten in das Datenverarbeitungssystem eingefügt sind und somit zwei form- und funktionsgleiche zusätzliche I/O-Schnittstellen, welche zur gemeinsamen Rückseitenplatine hin gerichtet sind, ermöglichen.

Die Figur 2 zeigt in einer Ausschnittsdarstellung ein Ausführungsbeispiel für eine Kontaktierung der ersten Tochterkarte 360 mit der Hauptplatine 200 des Datenverarbeitungssystems 100. Bei diesem Ausführungsbeispiel ist die Kontaktierung mittels der ersten RISER-Karte 330 in der Form gebildet, dass die erste RISER-Karte 330 in der ersten Steckkontaktleiste 300 aufgenommen ist. Die erste Tochterkarte 360 umfasst eine erste Leiterplattendurchführung 370. Diese erste Leiterplattendurchführung 370 ist von einer ersten Steckkontaktleiste 380 der ersten Tochterkarte 360 umgeben. Die erste Leiterplattendurchführung 370 ist der Form und Größe der ersten RISER-Karte 330 angepasst, so dass die erste RISER-Karte 330 in die erste Leiterplattendurchführung 370 einsteckbar ist. Zur Kontaktbildung von der Hauptplatine 200 zur ersten Tochterkarte 360 wird die erste RISER-Karte 330 in die erste Steckkontaktleiste 300 auf der Hauptplatine 200 eingeführt. Die erste RISER-Karte 330 ist dann vertikal zur Ebene der Hauptplatine 200 angeordnet. Die erste Tochterkarte 360 ist mit der ersten RISER-Karte 330 derart gekoppelt, dass die erste RISER-Karte 330 in die erste Leiterplattendurchführung 370 eingeführt ist. Dadurch ergibt sich eine Anordnung der ersten Tochterkarte 360 parallel zur Hauptplatine 200. Die erste RISER-Karte 330 ist derart ausgeführt, dass auf einer vorbestimmbaren Wegstrecke H die Kontakte der ersten RISER-Karte 330 in Form mehrerer paralleler Kontaktbahnen ausgebildet sind. Somit ist die erste Tochterkarte 360 auf der ersten RISER-Karte 330 in verschiedenen Höhenebenen anordenbar, ohne dass Unterbrechungen der Kontaktierungen entstehen.

Die elektrischen Kontakte von der ersten RISER-Karte 330 zur ersten Tochterkarte 360 werden demzufolge durch die erste Steckkontaktleiste 380 der Tochterkarte 360 gebildet. Die erste Steckkontaktleiste 300 und die Steckkontaktleiste 380 der ersten Tochterkarte 360 sind mittels Lötverbindungen mit den jeweiligen Leiterbahnen der Hauptplatine 200 beziehungsweise der ersten Tochterkarte 360 verbunden.

Die Darstellung des Ausführungsbeispiels in der Figur 2 umfasst weiter auch die Anordnung der zweiten Tochterkarte 460. Die Anordnung der zweiten Tochterkarte 460 entspricht dem oben genannten Prinzip der Achsenspiegelung an der Spiegelachse 500 in Folge einer um die Achse 500 gespiegelten ersten Tochterkarte 360. Die zweite Tochterkarte 460 ist bau- und funktionsgleich mit der ersten Tochterkarte 360. Die zweite Tochterkarte 460 umfasst eine zweite Leiterplattendurchführung 470, welche ausgebildet ist die zweite RISER-Karte 430 aufzunehmen. Die zweite Leiterplattendurchführung 470 ist von einer zweiten Steckkontaktleiste 480 der zweiten Tochterkarte umgeben. Die zweite RISER-Karte 430 ist in die zweite Steckkontaktleiste 400 eingefügt, welche auf der Hauptplatine 200 gegenüber der ersten Steckkontaktleiste 300 angeordnet ist. Die zweite Leiterplattendurchführung 470 nimmt mit der zweiten Steckkontaktleiste 480 die in die zweite Leiterplattendurchführung 470 hineingesteckte RISER-Karte 430 auf. Elektrische Kontakte sind mittels der zweiten Steckkontaktleiste 480 gebildet. Dazu weist die zweite RISER-Karte 430 an ihrer Oberfläche längsgerichtete parallele Leiterbahnen auf, die mit den elektrischen Kontakten der zweiten Steckkontaktleiste 480 zusammenwirken. Ebenso wie die RISER-Karte 330 ist auch die RISER-Karte 430 über eine vorbestimmte Wegstrecke H' mit diesen Leiterbahnstreifen versehen. Diese ermöglichen ein exaktes Justieren der Tochterkarte 460 über die gesamte Wegstrecke H'.

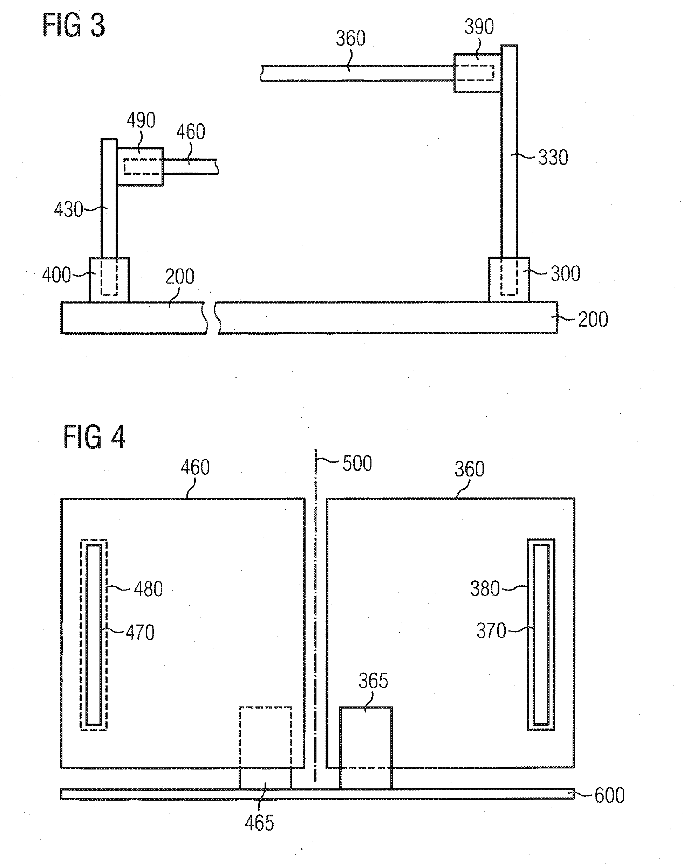

Die Figur 3 zeigt Abschnitte des Datenverarbeitungssystems 100, wobei die Anordnung der Tochterkarten 360,460, insbesondere die Bildung der elektrischen Kontakte zwischen der Hauptplatine 200 und den Tochterkarten 360,460, gemäß einem zweiten Ausführungsbeispiel gebildet ist. Dieses Ausführungsbeispiel unterscheidet sich unter anderem durch die Verwendung einer ersten RISER-Karte 330 und einer zweiten RISER-Karte 430. Die erste RISER-Karte 330 umfasst eine Steckkontaktleiste 390 zur Aufnahme der ersten Tochterkarte 360. Gegenüberliegend zu der Steckkontaktleiste 390 weist die erste RISER-Karte 330 Kontakte auf, mit welchen sie in die erste Steckkontaktleiste 300 der Hauptplatine 200 eingeführt ist. Zur Anordnung der zweiten Tochterkarte 460 ist die zweite RISER-Karte 430 vorgesehen, die sich in ihrer Höhe von der ersten RISER-Karte 330 unterscheidet. Die zweite RISER-Karte 430 weist eine Steckkontaktleiste 490 auf. Diese ist an einer Außenseite der zweiten RISER-Karte 430 angeordnet. Gegenüber von dieser Außenseite weist die zweite RISER-Karte Kontakte auf, mit welchen sie in die Steckkontaktleiste 400 der Hauptplatine 200 eingeführt ist. Die unterschiedliche Höhe beziehungsweise unterschiedliche Ausführungsform der zweiten RISER-Karte 430 zur ersten RISER-Karte 330 ermöglicht es, die Tochterkarten 360 und 460 gemäß der Achsenspiegelung anzuordnen, und somit die asymmetrisch auf der Tochterkarte angeordneten I/O-Schnittstellen 365 und 465 derart auszurichten, dass sie auf einer gleichen Höhe zueinander fluchtend angeordnet sind.

Die Figur 4 zeigt in einer Draufsicht die beiden Tochterkarten 360 und 460, welche gemäß der Achsenspiegelung an der Spiegelachse 500 angeordnet sind. Die Tochterkarten 360 und 460 in der Figur 4 entsprechen dem Ausführungsbeispiel der Figur 2. Die erste Tochterkarte 360 dieses Ausführungsbeispiels umfasst die erste Leiterplattendurchführung 370 und die zweite Tochterkarte 460 dieses Ausführungsbeispiels umfasst die zweite Leiterplattendurchführung 470. Bei beiden Tochterkarten 360 und 460 sind die Leiterplattendurchführungen 370 und 470 von der ersten Steckkontaktleiste 380 beziehungsweise der zweiten Steckkontaktleiste 480 umgeben. Die erste und die zweite Tochterkarte 360 und 460 umfassen jeweils eine I/O-Schnittstelle 365 beziehungsweise 465. Die erste I/O-Schnittstelle 365 und die zweite I/O-Schnittstelle 465 sind im Datenverarbeitungssystem 100 so angeordnet, dass beide zur gemeinsamen Rückseitenplatine 600 gerichtet sind. Die gemeinsame Rückseitenplatine 600 bildet für dieses Datenverarbeitungssystem 100 und für alle in dem erwähnten Einbaurahmen eingeschobenen Datenverarbeitungssysteme eine gemeinsame Schnittstellenplatine.

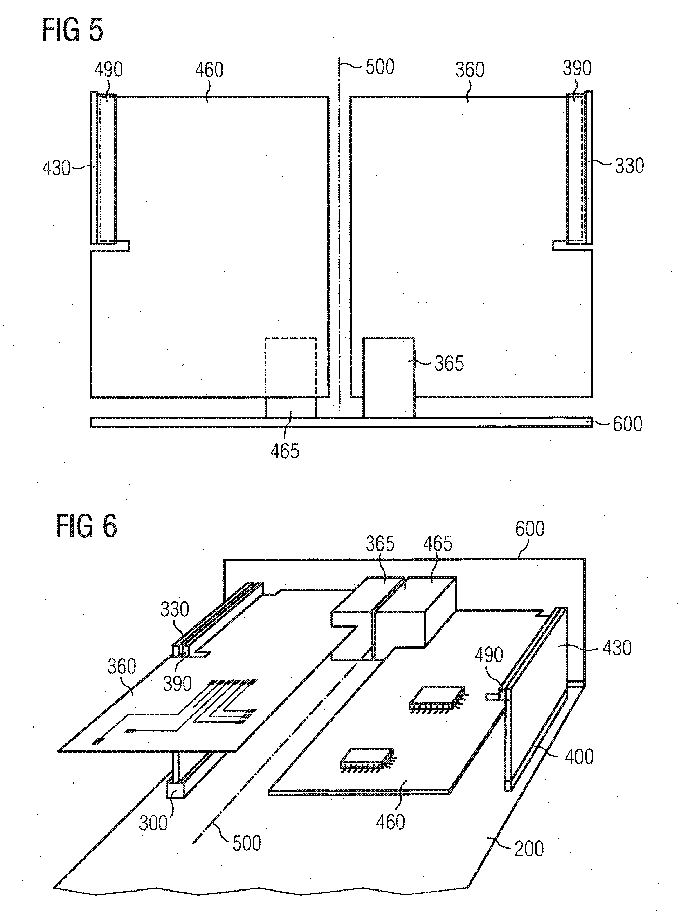

Die Figur 5 zeigt die erste Tochterkarte 360 und die zweite Tochterkarte 460 in der Anordnung nach dem Ausführungsbeispiel aus der Figur 3 gemäß der Achsenspiegelung an der Spiegelachse 500 in einer Draufsicht. Die Ausbildung von elektrischen Kontakten ist demzufolge gemäß dem aus Figur 3 bekannten Ausführungsbeispiel gebildet. Die erste Tochterkarte 360 und die zweite Tochterkarte 460 sind bei diesem Ausführungsbeispiel bau- und funktionsgleich in dem Datenverarbeitungssystem 100 angeordnet. Die erste RISER-Karte 330 umfasst die erste Steckkontaktleiste 390 und die zweite RISER-Karte 430 umfasst die zweite Steckkontaktleiste 490. In diesen Steckkontaktleisten 390 und 490 ist je eine Tochterkarte 360 oder 460 aufgenommen.

Figur 6 zeigt eine perspektivische Darstellung des Datenverarbeitungssystems 100 gemäß dem Ausführungsbeispiel aus der Figur 5 und der Figur 3. Die erste Tochterkarte 360 ist mit einer Seite, welche die Leiterbahnen aufweist, nach oben gerichtet und in der ersten Steckkontaktleiste 390 der ersten RISER-Karte 330 aufgenommen. Die erste RISER-Karte 330 ist in der ersten Steckkontaktleiste 300 der Hauptplatine 200 aufgenommen. Die zweite Tochterkarte 460 ist zur ersten Tochterkarte 360 so angeordnet, als wäre sie an der Spiegelachse 500 gespiegelt. Mittels formverschiedener RISER-Karten 330 und 430 sind die I/O-Schnittstellen 365 und 465 derart in dem Datenverarbeitungssystem 100 angeordnet, dass die I/O-Schnittstellen auf einer gemeinsamen Ebene fluchten. Die Oberfläche der ersten Tochterkarte 360, welche zur Hauptplatine gerichtet ist, ist bei der bau- und funktionsgleichen Tochterkarte 460 nach oben gerichtet. Die zweite Tochterkarte 460 scheint gegenüber der Tochterkarte 360 um die Achse 500 herumgeklappt. Die I/O-Schnittstellen 365 und 465 bilden mit der gemeinsamen Rückseitenplatine 600 elektrische Kontakte. Die gemeinsame Rückseitenplatine 600 bildet für sämtliche Datenverarbeitungssysteme in einem Baugruppenträger eine gemeinsame Schnittstellenplattform.

Für alle Ausführungsbeispiele gilt, dass die Tochterkarten alleine mit den Steckkontaktleisten und den dadurch gebildeten mechanischen Verbindungen nicht ausreichend im Datenverarbeitungssystem festgelegt sind. Es ist demzufolge vorteilhaft noch eine zusätzliche mechanische Befestigung vorzusehen, um die Tochterkarten im Datenverarbeitungssystem festzulegen und somit störungsfreie elektrische Kontakte an den Kontaktstellen der Steckkontaktleisten auch über längere Zeiträume sicherzustellen.

### Bezugszeichenliste

- 100: Datenverarbeitungssystem
- 200: Hauptplatine
- 210: I/O-Schnittstelle (Hauptplatine)
- 220: Hauptprozessor
- 230: RAM-Arbeitsspeicher
- 300: Erste Steckkontaktleiste (Hauptplatine)
- 330: Erste RISER-Karte
- 360: Erste Tochterkarte
- 365: I/O-Schnittstelle (erste Tochterkarte)
- 370: Leiterplattendurchführung (erste Tochterkarte)
- 380: Steckkontaktleiste (erste Tochterkarte)
- 390: Steckkontaktleiste (erster RISER-Karte)
- 400: Zweite Steckkontaktleiste (Hauptplatine)
- 430: Zweite RISER-Karte
- 460: Zweite Tochterkarte
- 465: I/O-Schnittstelle (zweite Tochterkarte)
- 470: Leiterplattendurchführung (zweite Tochterkarte)
- 480: Steckkontaktleiste (zweite Tochterkarte)
- 490: Steckkontaktleiste (zweite RISER-Karte)
- 500: Spiegelachse
- 600: Gemeinsame Rückseitenplatine
- H: Wegstrecke (erste RISER-Karte)
- H': Wegstrecke (zweite RISER-Karte)

## Patentansprüche

1. Datenverarbeitungssystem (100), mit einer Hauptplatine (200), bei dem die Hauptplatine (200) zumindest eine erste Steckkontaktleiste (300) aufweist, in welcher eine erste RISER-Karte (330) aufgenommen ist und in die erste RISER-Karte (330) eine erste Tochterkarte (360) derart aufgenommen ist, dass die erste Tochterkarte (360) parallel zur Hauptplatine (200) angeordnet ist,
und bei dem die Hauptplatine (200) eine zweite Steckkontaktleiste (400) aufweist, und in der zweiten Steckkontaktleiste (400) eine zweite RISER-Karte (430) aufgenommen ist, und in der zweiten RISER-Karte (430) eine zweite Tochterkarte (460) derart aufgenommen ist, dass die zweite Tochterkarte (460) parallel zur Hauptplatine (200) angeordnet ist, wobei die erste Steckkontaktleise (300) und die zweite Steckkontaktleiste (400) jeweils an zueinander gegenüber liegenden Außenseiten der Hauptplatine (200) angeordnet sind,
**dadurch gekennzeichnet, dass**
jede Tochterkarte (360, 460) jeweils eine I/O-Schnittstelle (365, 465) umfasst, die I/O-Schnittstellen (365, 465) der Tochterkarten (360, 460) jeweils mit einer gemeinsamen Rückseitenplatine (600) zusammenwirken und zur gemeinsamen Rückseitenplatine hin gerichtet sind, und die erste Tochterkarte (360) zu der zweiten Tochterkarte (460) um eine parallel zur Hauptplatine (200) verlaufenden Achse (500) um 180° gedreht angeordnet ist und die erste Tochterkarte (360) und die zweite Tochterkarte (460) form- und funktionsgleich sind.

2. Datenverarbeitungssystem nach Patentanspruch 1,
**dadurch gekennzeichnet, dass**
die erste RISER-Karte (330) und die zweite RISER-Karte (430) jeweils eine Steckkontaktleiste (390, 490) aufweisen, die jeweils dazu ausgebildet ist, eine Tochterkarte (360, 460) aufzunehmen.

3. Datenverarbeitungssystem nach einem der Patentansprüche 1 und 2,
**dadurch gekennzeichnet, dass**
die Tochterkarte (360, 460) eine Steckkontaktleiste (380, 480) aufweist, welche dazu ausgebildet ist, eine RISER-Karte (330, 430) aufzunehmen.

4. Datenverarbeitungssystem nach Patentanspruch 3,
**dadurch gekennzeichnet, dass**
die Tochterkarte (360, 460) eine Leiterplattendurchführung (370, 470) aufweist, welche von der Steckkontaktleiste (380, 480) umgeben ist und dazu ausgebildet, ist eine RISER-Karte (330, 430) aufzunehmen.

5. Datenverarbeitungssystem nach einem der vorhergehenden Patentansprüche 1 bis 4,
**dadurch gekennzeichnet, dass**
die Hauptplatine (200) zumindest eine I/O-Schnittstelle (210) aufweist und auf der Hauptplatine (200) zumindest ein Hauptprozessor (220) und/oder ein RAM-Arbeitsspeicher (230) anordenbar ist.

6. Datenverarbeitungssystem nach einem der Patentansprüche 1 bis 5,
**dadurch gekennzeichnet, dass**
aus einer Mehrzahl von Datenverarbeitungssystemen (100) ein modular aufgebautes Serversystem ausgebildet ist, wobei das einzelne Datenverarbeitungssysteme (100) als Einschub ausgebildet ist, welcher in einem Einbaurahmen aufgenommen ist.

## Claims

1. Data-processing system (100), having a main board (200), in which data-processing system the main board (200) has at least one first plug contact strip (300) in which a first riser card (330) is held, and a first daughter card (360) is held in the first riser card (330) in such a way that the first daughter card (360) is arranged parallel to the main board (200), and in which data-processing system the main board (200) has a second plug contact strip (400), and a second riser card (430) is held in the second plug contact strip (400), and a second daughter card (460) is held in the second riser card (430) in such a way that the second daughter card (460) is arranged parallel to the main board (200), wherein the first plug contact strip (300) and the second plug contact strip (400) are each arranged on the outer sides of the main board (200) which are situated opposite one another, **characterized in that** each daughter card (360, 460) in each case comprises an I/O interface (365, 465), the I/O interfaces (365, 465) of the daughter cards (360, 460) in each case interact with a common backplane (600) and are directed toward the common backplane, and the first daughter card (360) is arranged in a manner rotated through 180° about an axis (500), which runs parallel to the main board (200), in relation to the second daughter card (460), and the first daughter card (360) and the second daughter card (460) are dimensionally and functionally identical.

2. Data-processing system according to Patent Claim 1, **characterized in that** the first riser card (330) and the second riser card (430) in each case have a plug contact strip (390, 490) which is in each case designed to hold a daughter card (360, 460).

3. Data-processing system according to either of Patent Claims 1 and 2, **characterized in that** the daughter card (360, 460) has a plug contact strip (380, 480) which is designed to hold a riser card (330, 430).

4. Data-processing system according to Patent Claim 3, **characterized in that** the daughter card (360, 460) has a printed circuit board bushing (370, 470) which is surrounded by the plug contact strip (380, 480) and is designed to hold a riser card (330, 430).

5. Data-processing system according to one of preceding Patent Claims 1 to 4, **characterized in that** the main board (200) has at least one I/O interface (210), and at least one main processor (220) and/or a RAM working memory (230) can be arranged on the main board (200).

6. Data-processing system according to one of Patent Claims 1 to 5, **characterized in that** a server system of modular construction is formed from a plurality of data-processing systems (100), wherein the individual data-processing system (100) is designed as an insert which is held in a mounting frame.

## Revendications

1. Système de traitement de données (100), comportant une carte mère (200), dans lequel la carte mère (200) comprend au moins un premier connecteur multipoint (300) dans lequel est reçue une première carte adaptatrice (330), et une première carte fille (360) est reçue dans la première carte adaptatrice (330) de manière à ce que la première carte fille (360) soit disposée parallèlement à la carte mère (200),
et dans lequel la carte mère (200) comporte un second connecteur multipoint (400) et une seconde carte adaptatrice (430) est reçue dans le second connecteur multipoint (400), et une seconde carte fille (460) est reçue dans la seconde carte adaptatrice (430) de manière à ce que la seconde carte fille (460) soit disposée parallèlement à la carte mère (200), dans lequel le premier connecteur multipoint (300) et le second connecteur multipoint (400) sont respectivement disposés sur des faces extérieures opposées l'une à l'autre de la carte mère (200),
**caractérisé en ce que** chaque carte fille (360, 460) comprend respectivement une interface d'entrée/sortie (365, 465), **en ce que** les interfaces d'entrée/sortie (365, 465) des cartes filles (360, 460) coopèrent respectivement avec un fond de panier commun (600) et sont dirigées vers le fond de panier commun, et la première carte fille (360) est disposée de manière tournée de 180° par rapport à la seconde carte fille (460) autour d'un axe (500) s'étendant parallèlement à la carte mère (200) et la première carte fille (360) et la seconde carte fille (460) ont des formes et des fonctions identiques.

2. Système de traitement de données selon la revendication 1, **caractérisé en ce que** la première carte adaptatrice (360) et la seconde carte adaptatrice (430) comportent respectivement un connecteur multipoint (390, 490) qui est conçu pour recevoir une carte fille (360, 460).

3. Système de traitement de données selon l'une quelconque des revendications 1 et 2, **caractérisé en ce que** la carte fille (360, 460) comporte un connecteur multipoint (380, 480) qui est conçu pour recevoir une carte adaptatrice (330, 430).

4. Système de traitement de données selon la revendication 3, **caractérisé en ce que** la carte fille (360, 460) présente la forme de réalisation d'une carte de circuit imprimé (370, 470) qui est entourée par le connecteur multipoint (380, 480) et est conçue pour recevoir une carte adaptatrice (330, 430).

5. Système de traitement de données selon l'une quelconque des revendications 1 à 4 précédentes, **caractérisé en ce que** la carte mère (200) comporte au moins une interface d'entrée/sortie (210) et **en ce qu'**au moins un processeur principal (220) et/ou une mémoire de travail de type RAM (230) peut être disposé sur la carte mère (200).

6. Système de traitement de données selon l'une quelconque des revendications 1 à 5, **caractérisé en ce qu'**un système serveur modulaire est réalisé à partir d'une pluralité de systèmes de traitement de données (100), dans lequel le système de traitement de données individuel (100) est réalisé sous la forme d'un tiroir qui est reçu dans un châssis.
